# EUROPEAN PATENT APPLICATION

(11) **EP 4 456 424 A1**
(43) Date of publication of application: **30.10.2024**
(21) Application number: 23203385.2
(22) Date of filing: 13.10.2023
(51) Int. Cl.: H03K 5/24, G01R 19/165

(54) **STRUCTURE WITH DIFFERENTIAL AMPLIFIERS HAVING INPUT OFFSET AND RELATED METHODS**

(30) Priority: 25.04.2023 US 202318306311
(71) Applicant: GlobalFoundries Dresden Module One Limited Liability Company & Co. KG, 01109 Dresden (DE)
(72) Inventor: Stefanov, Stefan Manolov, 1700 Sofia (BG)
(74) Representative: Grünecker Patent- und Rechtsanwälte PartG mbB

(57) **Abstract**

Embodiments of the disclosure provide a structure with differential amplifiers (110, 112) each having an input offset, and related methods. A structure of the disclosure includes a first differential amplifier (110) coupled to an input line (114), a reference line (116), and a first output line (Out1). The first differential amplifier has a first input offset. A second differential amplifier (112) is coupled to the input line (114), the reference line (116) and to a second output line (Out2). The second differential amplifier has a second input offset in a different direction from the first input offset.

## Description

### BACKGROUND

The rise of networking devices, such as the "Internet of Things" (IoT), with links to a data center has expanded the need for reliable digital circuitry, particularly memory components on a chip, which may be required for seamless system operation. Some memory or logic components may compare the voltage of a particular signal with more than one value at once, e.g., to compare the signal with relevant minimum and maximum levels. Conventional comparator structures for this function may use current sources to provide the reference voltage(s) for comparison, but these circuits typically have a finite input resistance and may unintentionally distort information encoded within the signal. Although some circuits attempt to address this issue using a resistive divider with the current sources, this approach electrically loads the input signal and thus creates inherent distortion.

### SUMMARY

All aspects, examples and features mentioned below can be combined in any technically possible way.

Aspects of the disclosure provide a structure including: a first differential amplifier coupled to an input line, a reference line, and a first output line, wherein the first differential amplifier has a first input offset; and a second differential amplifier coupled to the input line, the reference line, and a second output line, wherein the second differential amplifier includes a second input offset in a different direction from the first input offset.

Further aspects of the disclosure provide a structure including: a first differential amplifier coupled to an input line, a reference line having a reference voltage, and a first output line, wherein the first differential amplifier has a first input offset; a second differential amplifier coupled to the input line, the reference line, and a second output line, wherein the second differential amplifier has a second input offset in a different direction from the first input offset; and a digital circuit coupled to the first output line and the second output line, wherein the digital circuit is configured to indicate whether a voltage in the input line is lower than a difference between the reference voltage and the first input offset or greater than a sum of the reference voltage and the second input offset.

Additional aspects of the disclosure provide a method including: transmitting an input signal to a first differential amplifier via an input line, wherein the first differential amplifier is coupled to a reference voltage and has a first input offset; transmitting the input signal to a second differential amplifier via the input line, wherein the second differential amplifier is coupled to the reference voltage and has a second input offset in a different direction from the first input offset; and determining, based on an output from the first differential amplifier and an output from the second differential amplifier, whether the input signal is lower than a difference between the reference voltage and the first input offset or greater than a sum of the reference voltage and the second input offset.

Two or more aspects described in this disclosure, including those described in this summary section, may be combined to form implementations not specifically described herein.

The details of one or more implementations are set forth in the accompanying drawings and the description below. Other features, objects and advantages will be apparent from the description and drawings, and from the claims.

### BRIEF DESCRIPTION OF THE DRAWINGS

These and other features of this disclosure will be more readily understood from the following detailed description of the various aspects of the disclosure taken in conjunction with the accompanying drawings that depict various embodiments of the disclosure, in which:
FIG. 1 shows a schematic diagram of a signal source, comparator, and digital circuit for interpreting voltage levels according to embodiments of the disclosure.
FIG. 2 shows a schematic diagram of a structure according to embodiments of the disclosure.
FIG. 3A shows a schematic diagram of a structure with asymmetrically sized transistors according to embodiments of the disclosure.
FIG. 3B shows an expanded schematic diagram of a first differential amplifier with asymmetrically sized transistors according to embodiments of the disclosure.
FIG. 3C shows an expanded schematic diagram of a second differential amplifier with asymmetrically sized transistors according to embodiments of the disclosure.
FIG. 4A shows an expanded schematic diagram of a first differential amplifier with asymmetrically sized resistors according to embodiments of the disclosure.
FIG. 4B shows an expanded schematic diagram of a second differential amplifier with asymmetrically sized resistors according to embodiments of the disclosure.
FIG. 5 shows a schematic diagram of a structure and digital circuit according to embodiments of the disclosure.
FIG. 6 shows a schematic diagram of a structure and XOR gate according to embodiments of the disclosure.
FIG. 7 shows an illustrative flow diagram of an operational methodology according to embodiments of the disclosure.

It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION

In the following description, reference is made to the accompanying drawings that form a part thereof, and in which is shown by way of illustration specific exemplary embodiments in which the present teachings may be practiced. These embodiments are described in sufficient detail to enable those skilled in the art to practice the present teachings, and it is to be understood that other embodiments may be used and that changes may be made without departing from the scope of the present teachings. The following description is, therefore, merely illustrative.

Embodiments of the present disclosure provide structures and related methods for differential amplifiers having input offsets. Embodiments of the disclosure differ from conventional circuit structures by directly defining a voltage offset between input and reference voltages within the structure of the differential amplifier, rather than using external components to define multiple reference voltages for comparison. A structure according to the disclosure may include a first differential amplifier coupled to an input line, a reference line, and a first output line. A differential amplifier is an amplifier circuit configured to output a signal based on, and proportionate to, two input signals.

The first differential amplifier may include a first input offset, e.g., due to having differently sized transistors and/or distinct resistors therein. An "input offset" refers to a difference in threshold voltage between two transistors. An "input offset," as defined herein, refers to the input differential voltage (i.e., the voltage difference between the two inputs to the differential amplifier) required for the differential amplifier to be saturated. Thus, an "input offset" may be expressed as units of voltage. The structure also includes a second differential amplifier coupled to the input line, the reference line, and a second output line. The second differential amplifier has a second input offset that is in an opposite direction from the first input offset. That is the difference in threshold voltage between transistors in the second differential amplifier is the same as in the first differential amplifier, but the input voltage and reference voltage are applied to opposite transistors. In contrast to conventional comparator circuits, in which multiple reference signals are compared with the same input signal, embodiments of the disclosure use different input offsets in each differential amplifier to compare the input voltage with different voltage levels using the same reference line.

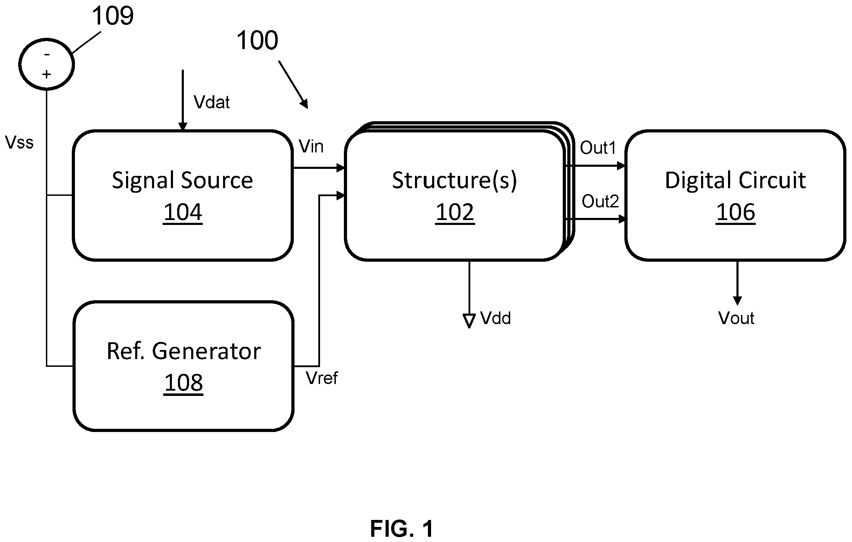

FIG. 1 depicts a schematic diagram of a device 100 where one or more structures 102 may be implemented according to embodiments of the disclosure. Structure(s) 102 may be electrically interposed between a signal source 104 (i.e., any electrical component(s) for generating a signal to be interpreted) and a digital circuit 106 and/or logic gates or other combinations hardware or software elements for interpreting data encoded in a voltage ("Vin") from signal source 104. Structure(s) 102 may generate a pair of output voltages ("Out1," "Out2"), each indicating whether input signal Vin to structure 102 is greater or less than a compared voltage derived from a reference voltage ("Vref"). The compared voltage(s) may be a sum of reference voltage Vref and one input offset (e.g., produced in one differential amplifier) or the difference between reference voltage Vref and another input offset (e.g., produced in another differential amplifier). The input offsets for each differential amplifier may be similar in magnitude in opposite directions, thus enabling different comparisons in each amplifier. In some implementations, the input offsets for each differential amplifier may be in a different direction (i.e., one may be added to the threshold voltage and another may be subtracted), but also may have a different magnitude. Digital circuit 106 in turn may provide an output signal ("Vout") combining the value(s) encoded in each output voltage Out1, Out2. Signal source 104 may be any currently known or later developed electrical instrument for producing Vin in the form of a direct current (DC) waveform or other measurable voltage, and thus the details of signal source 104 need not be discussed in further detail. Similarly, digital circuit 106 may be any electrical device, component, etc., capable of interpreting data in input signal Vin and/or implementing various functions based on input signal Vin. A reference voltage generator 108 can transmit reference voltage Vref as a signal to structure(s) 102 for comparison with voltage Vin as discussed herein.

A power supply 109 (e.g., a battery and/or connection to the grid or other external sources of electrical power) may generate a supply voltage Vss for operating signal source 104 and reference voltage generator 108. Reference voltage Vref may be directly proportionate to supply voltage Vss (e.g., it may be set to a voltage that is some fraction of supply voltage Vss), whereas input signal Vin may depend on electrical inputs ("Vdat") provided to signal source 104, e.g., from external hardware, electrical transducers, etc. The subcomponents of signal source 104, digital circuit 106, and reference generator 108 are not otherwise relevant to the components of structure(s) 102, and thus not discussed in further detail herein.

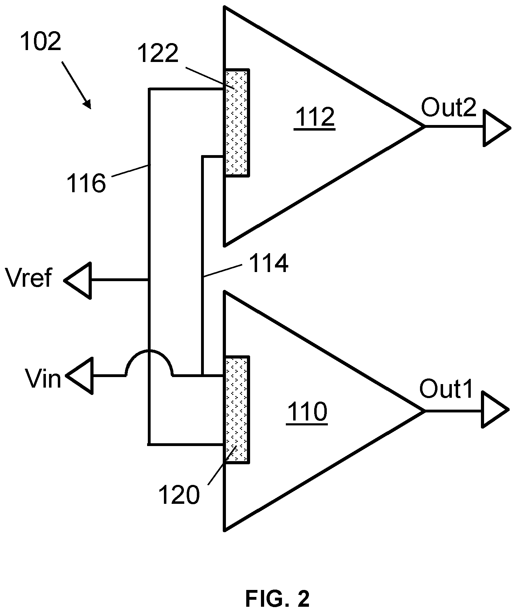

FIG. 2 depicts as schematic view of structure 102 according to embodiments of the disclosure. Structure 102 may include, e.g., a first differential amplifier 110 and a second differential amplifier, each coupled to an input line 114 for transmitting input signal Vin and a reference line 116 for transmitting reference voltage Vref. Each differential amplifier 110, 112 may be embodied as any currently known or later developed circuit structure for producing an electrical output indicating a difference between the voltage of two signals transmitted as inputs to the differential amplifier. Each differential amplifier 110, 112 may produce a corresponding output voltage ("Out1," "Out2," respectively) that indicates and amplifies the voltage difference between each signal (Vin, Vref) that is input to differential amplifier 110, 112. Differential amplifiers 110, 112 may be implemented in integrated circuit (IC) technology through a combination of resistors and transistors, e.g., using serially connected subcircuits including an input current mirror, a comparator, and output current mirror, according to any desired configuration. The details for structuring an operating such amplifier circuits and/or their sub-components are generally known in the art.

The components of each differential amplifier 110, 112 may affect its multiplier, i.e., the value by which each differential amplifier 110, 112 multiplies the voltage difference between signals Vin, Vref. In embodiments of the disclosure, differential amplifiers 110, may be configured to compare input signal Vin with two values using only one reference voltage Vref. Embodiments of structure 102 are thus different from conventional comparator circuits, e.g., those which compare one input signal with two or more distinct reference voltages using pairs of transistors that have substantially identical threshold voltages.

Each differential amplifier 110, 112 may include an offset component 120 (within amplifier 110), 122 (within amplifier 112). Each offset component 120, 122 may be embodied as one or more subcomponents configured to provide an input offset within its differential amplifier 110, 112. Specifically, each offset component 120, 122 provides an input offset by modifying the voltage of input signal Vin and/or reference voltage Vref before it is compared with the other signal provided to differential amplifier 110, 112. The amount of offset in each differential amplifier 110, 112, may be similar but in an opposite direction. In one example, offset component 120 may be a pair of transistors in which one transistor has a different threshold voltage (i.e., minimum voltage needed to enable or disable source/drain current through the transistor) from the other transistor of the pair. In a further example, offset component(s) 120, 122 may be a pair of resistive couplings to source/drain (S/D) terminals of each transistor, in which one of the two resistors has a different resistance from the other. These and other examples are discussed in further detail herein.

Offset component(s) 120, 122, however implemented, may be operable to change the magnitude of input signal Vin and/or reference voltage Vref, such that each differential amplifier 110, 112 produces a different output despite receiving the same input line 114 and reference line 116. These differences in output arise from the input voltage Vin and reference voltage Vref being applied to different input nodes of each differential amplifier 110. The presence of offset component(s) 120, 122 in each differential amplifier 110, 112 may cause differential amplifier 110 to have a first input offset and differential amplifier 112 to have a second input offset in a different direction from the first input offset. The different directions may arise from, e.g., input voltage Vin being applied to the gate of a higher threshold voltage transistor in first differential amplifier 110 and the gate of a lower threshold voltage transistor in second differential amplifier 110, and vice versa for reference voltage Vref. Offset component 120 may add a predetermined amount to the difference between input signal Vin and reference signal Vref while offset component 122 may subtract a predetermined amount from the difference between input signal Vin and reference signal Vref, or vice versa. During operation, offset components 120, 122 in each differential amplifier 110, 112 may enable structure 102 to compare input signal Vin with distinct voltage levels (e.g., minimum and maximum voltages) using only one reference voltage Vref in reference line 116. Thus, structure 102 may provide or function as a window comparator circuit without external hardware for changing the magnitude of reference voltage Vref before it is transmitted into differential amplifier(s) 110, 112.

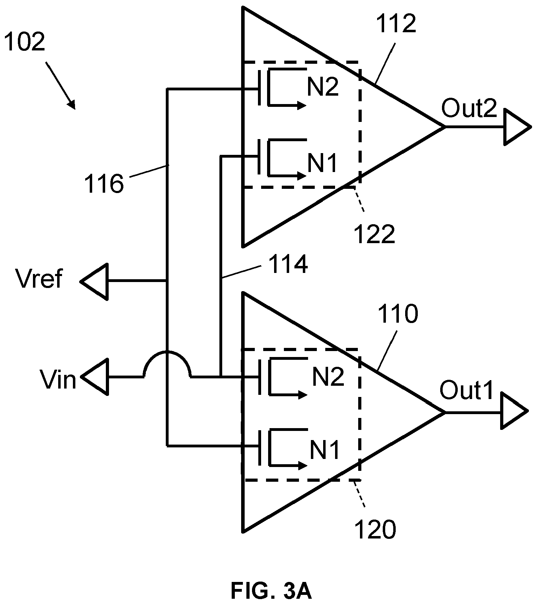

FIG. 3A depicts an implementation of structure 102 where offset components 120, 122 are implemented using pairs of asymmetrically sized transistors. Each offset component 120, 122 within a corresponding differential amplifier 110, 112 includes a first transistor ("N1") and a second transistor ("N2") having different sizes, i.e., different channel lengths, gate sizes, and/or other structural features that may cause transistors N1, N2 to be of a different size. The different sizes of each transistor N1, N2 may cause first transistor N1 to have a different threshold voltage from second transistor N2. Offset components 120, 122 themselves may be similar or identical, i.e., they may have similar or identical pairs of asymmetrically sized transistors N1, N2 therein. Transistors N1, N2 each may be connected to a different input, depending on whether they are included within first differential amplifier 110 or second differential amplifier 112. In an example, first offset component 120 of first differential amplifier 110 may include first transistor N1 coupled to reference line 116 and second transistor N2 coupled to input line 114. Second offset component 122 of second differential amplifier 112, by contrast, may include first transistor N1 coupled to input line 114 and second transistor N2 coupled to reference line 116.

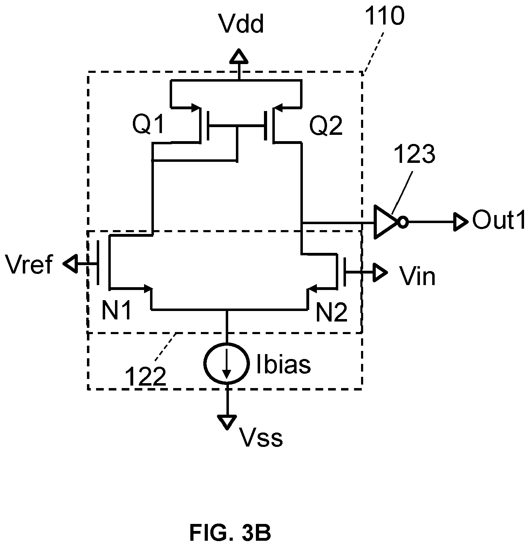

Turning to FIG. 3B, an expanded schematic view of first differential amplifier 110 is shown according to embodiments. First differential amplifier 110 may include asymmetrically sized transistors N1, N2 in which transistor N1 is larger than transistor N2. Reference voltage Vref may be coupled to the gate of transistor N1 and input voltage Vin may be coupled to the gate of transistor N2. First output Out1 may be coupled to the drain of transistor N2 through an inverter 123 (i.e., any currently known or later developed circuit configuration for inverting the polarity of a voltage without significantly affecting its magnitude). Each transistor N1, N2 may be coupled at its source to supply voltage Vss, e.g., through a biasing current source Ibias. Biasing current source Ibias may be embodied as any currently known or later developed current source, e.g., a current mirror circuit, such that first output Out1 from first differential amplifier 110 is dependent on the magnitude of input voltage Vin and/or reference voltage Vref. A pair of amplifier transistors Q1, Q2 may couple transistors N1, N2 to a drain voltage ("Vdd"), which may be set to ground or any other desired voltage.

As noted herein, transistors N1, N2 may be asymmetrically sized such that transistor N1 is larger than transistor N2. The difference in size between transistors N1, N2 may cause transistors N1, N2 to have different multiplication factors, i.e., a dimensionless quantity indicating the amount of source-to-drain current supported within each transistor. According to an example, transistor N1 may have a larger multiplication factor (e.g., twenty), where as transistor N2 may have a smaller multiplication factor (e.g., nineteen). In first differential amplifier, reference voltage Vref may be coupled to the larger transistor N1 and input voltage Vin may be connected to the smaller transistor N2. In this configuration, first transistor N1 will increase the voltage to which input voltage Vin is compared, i.e., it may convert reference voltage Vref into an upper voltage limit.

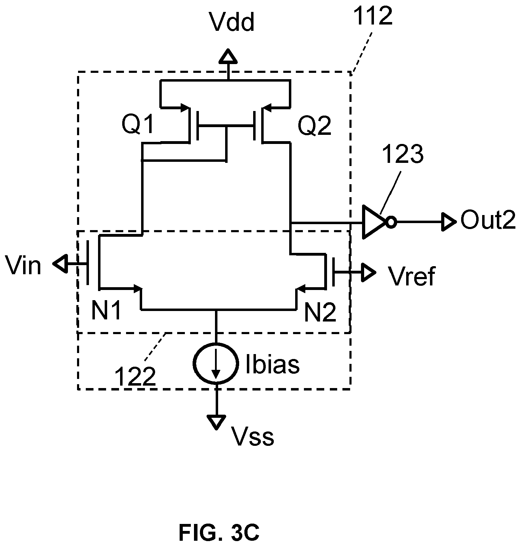

FIG. 3C depicts an expanded view of second differential amplifier 112 according to embodiments. Second differential amplifier 112 may be substantially identical to first differential amplifier 110 and thus may include asymmetrically sized transistors N1, N2 having similar or identical properties to those of first differential amplifier 110. According to the example discussed herein relative to FIG. 3B, second differential amplifier 112 may include transistor N1 having a larger multiplication factor than transistor N2. In second differential amplifier 112, however, input voltage Vin is now connected to the gate of the larger size transistor N1 and reference voltage Vref is now connected to the gate of the smaller size transistor N2 (i.e., these connections are swapped in first differential amplifier 112). In this configuration, second transistor N2 will decrease the voltage to which input voltage Vin is compared, i.e., it may convert reference voltage Vref into a lower voltage limit. Although FIGS. 3B and 3C depict simplified differential amplifiers for implementing offset components 120, 122 therein, it is understood that embodiments of the disclosure may be implemented in any currently known or later developed form of differential amplifier.

Referring to FIGS. 3A-3C together, the similar or identically sized pairs of transistors N1, N2 in each offset component 120, 122 connecting to different lines 114, 116 allows input line 114 to be compared against two voltages despite only one reference voltage Vref being transmitted in reference line 116. According to an example, reference voltage Vref may be set to a value of approximately 0.7 volts (V), whereas input line Vin may carry an input signal (Vin) having a voltage of approximately 0.5 volts. Differential amplifiers 110, 112 with offset components 120, 122 are not configured simply to compare input signal Vin with reference voltage Vref, but instead modify input signal Vin and/or reference voltage Vref to implement two different comparisons. The difference in threshold voltage between each transistor N1, N2 in first offset component 120 may be identical in magnitude but opposite in opposite directions to the difference in threshold voltage between each transistor N1, N2 in second offset component 122.

According to an example, transistors N1, N2 of first offset component 120 may compare input voltage Vin (e.g., 0.5 V) with a sum of reference voltage Vref (e.g., 0.7V) and the first offset (e.g., 0.3 V). By contrast, transistors N1, N2 of second offset component 122 create offset in a different direction and thus compare input voltage Vin (e.g., 0.5 V) with the difference between of reference voltage Ver (e.g., 0.7 V) and the first offset (e.g., 0.3 V). Thus, offset components 120, 122 cause amplifiers 110, 112 to compare input signal Vin (i.e., 0.5 V) with two different reference voltages (i.e., 0.4 V and 1.0 V) despite the same reference voltage being transmitted to both amplifiers 110, 112. In this arrangement, differential amplifiers 110, 112 act as a "window comparator circuit" for comparing input signal Vin with lower magnitude and higher magnitude output voltages. Output signal Out1 from first differential amplifier 110 indicates whether input signal Vin is less than an increased magnitude voltage, whereas output signal Out2 from second differential amplifier 112 indicates whether input signal Vin is greater than a decreased magnitude voltage. In further implementations, the properties of offset components 120, 122 may be different to provide other types of comparisons (e.g., whether the magnitude of input signal Vin is outside a predetermined range of voltages). The use of asymmetrically sized transistors N1, N2 may eliminate the need for resistive couplings from input line 114 to reference line 116, and/or similar resistive couplings between differential amplifiers 110, 112.

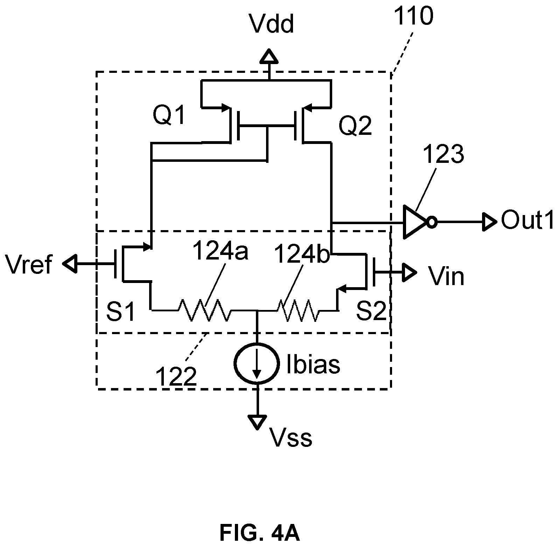

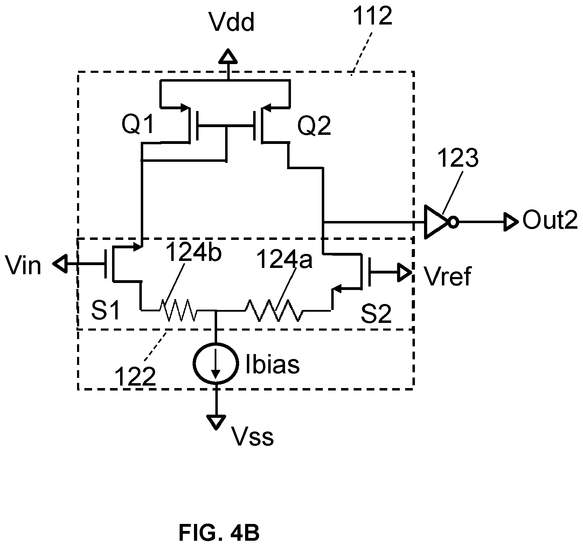

Referring to FIGS. 2, 4A, and 4B, offset components 120, 122 may be implemented in differential amplifiers 110, 112 without using asymmetrically sized transistors (e.g., transistors N1, N2 discussed elsewhere herein). For example, each offset component 120, 122 may have a pair of symmetrically sized transistors S1, S2 such that transistors S1, S2 do not induce an input offset within either differential amplifier 110, 112. Each pair of transistors S1, S2 may include transistors of substantially identical operating specifications (e.g., threshold voltage, gate to source voltage, source to drain voltage, etc.). Each offset component 120, 122 of structure 102 may include a pair asymmetrically sized resistors 124a, 124b, each coupled to an S/D terminal of one transistor S1. Each resistor 124a, 124b may be asymmetrically sized such that resistor 124a has a higher electrical resistance than resistor 124b. Resistor 124a may be coupled an S/D terminal of transistor S1, and resistor 124b may be coupled to an S/D terminal of transistor S1. Thus, transistor S1 coupled to reference voltage Vref has a low source-drain current compared to that of transistor S2 coupled to input voltage Vin. This difference in currents, in turn, induces an input offset within each amplifier 110, 112. The locations of each resistor 124a, 124b may be reversed in each amplifier, such that each amplifier 110, 112 has the same amount of input offset but in opposite directions..

By including a different configuration of resistors 124a, 124b in different amplifiers 110, 112 (e.g., coupling the larger size resistor 124a to transistor S2 in differential amplifier 110 but to transistor S1 in differential amplifier 112), offset components 120, 122 create an input offset in different directions are operable to compare input signal Vin with the higher and lower voltage levels. Thus, offset components 120, 122 provided using asymmetrically sized resistors 124a, 124b remain operable to provide a window comparator circuit as discussed herein. In still further implementations, offset component(s) 120, 122 may be any component or combination of components operable to modify the voltage level(s) of input signal Vin and reference voltage Vref within the physical hardware of differential amplifier(s) 110, 112, such that two differential amplifier(s) 110, 112 may implement different comparisons despite being coupled to the same input line 114 and reference line 116. In the case of resistors 124a, 124b, this may include coupling resistors 124a, 124b to the other S/D terminal of transistor(s) S1, S2 and/or providing asymmetrically sized resistors to create different amounts of current elsewhere within differential amplifier(s) 110, 112. Thus, differential amplifier(s) 110, 112 may take a variety of forms in one structure 102.

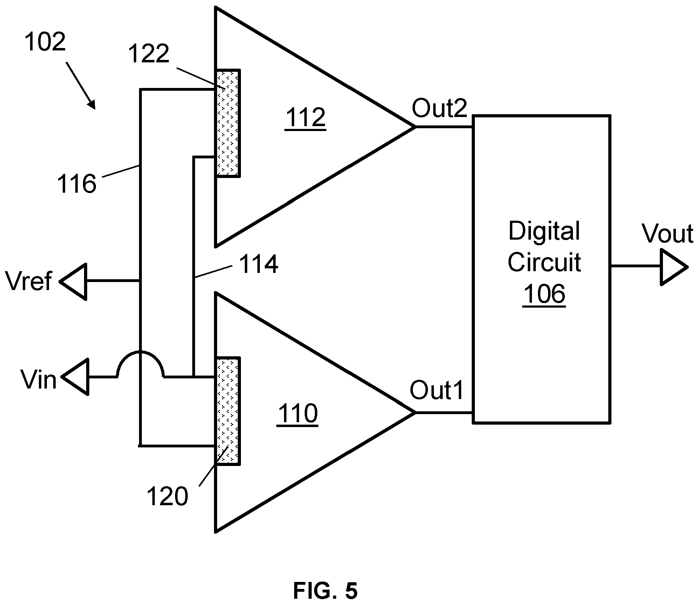

FIG. 5 depicts an example of structure 102 with digital circuit 106 to indicate how outputs from each differential amplifier 110, 112 may be interpreted or otherwise processed. Digital circuit 106 may include, e.g., circuitry or other components for converting outputs Out1, Out2 from each differential amplifier 110, 112 into one output signal Vout indicating the relationship between input signal Vin and each voltage to which it is compared. According to one example, first differential amplifier 110 may produce output Out1 indicating whether input signal Vin has a voltage that is less than an upper voltage level, and second differential amplifier 112 may produce output signal Out2 indicating whether input signal Vin has a voltage level greater than a lower voltage level. As discussed herein, the lower voltage level may be equal to the difference between reference voltage Vref and the first input offset defined by offset component 120, and the upper voltage level may be equal to the sum of reference voltage Vref and the second input offset defined by offset component 122. In this example, digital circuit 106 may include circuitry, logic gates, etc., to indicate whether outputs Out1, Out2 indicate that input signal Vin is between the upper and lower voltage levels.

In one example, digital circuit 106 can set output signal Vout to a logic "high" in response to input signal Vin being within a target range of voltages, i.e., output Out1 indicates that input signal Vin is above the lower voltage level and output signal Out2 indicates that input signal Vin is below the upper voltage level. Digital circuit 106 otherwise can output a logic "low" to indicate that input signal Vin is outside the target range of voltages. Digital circuit 106, in further examples, may include circuitry, logic, etc., for providing any conceivable indication based on outputs Out1, Out2 indicating the distinct comparisons in each differential amplifier 110, 112.

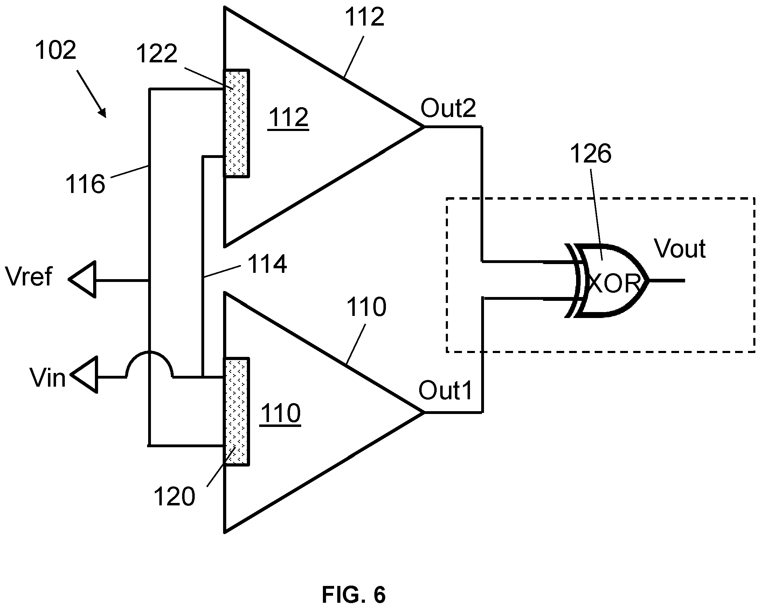

FIG. 6 depicts an additional example of structure 102, in which differential amplifiers 110, 112 transmit outputs Out1, Out2 to a logic gate 126 (e.g., an "exclusive or" or "XOR" gate) for providing output signal Vout solely based on the underlying function of logic gate 126. In the example of an XOR gate, logic gate 126 will output a "high" logic level only when the outputs Out1, Out2 transmitted thereto are at different logic levels. In the example of a window comparator circuit, first differential amplifier 110 may output a "high" logic level in response to input signal Vin being greater than a minimum voltage, whereas second differential amplifier 112 may output a "low" logic level in response to input signal Vin being less than a maximum voltage. Thus, outputs Out1, Out2 having the same logic level indicates that input signal Vin is outside the desired voltage range defined by the combination of differential amplifiers 110, 112. The voltage range may be defined similarly or identically to other embodiments discussed herein, e.g., a lower voltage level may be the difference between reference voltage Vref and a first input offset and an upper voltage level may be the sum of reference voltage Vref and a second input offset. Each offset component 120, 122 may define one of the two input offsets. To implement different types of comparisons (e.g., comparing whether input signal Vin is outside a range of undesirable voltage levels), logic gate 126 may be implemented as a different type of logic gate (e.g., exclusive nor gate ("XOR"), and gate ("AND"), etc.), and/or using a different number of logic gates 126 coupled to outputs Out1 Out2. In such cases, differential amplifiers 110, 112 may compare input signal Vin with a different set of voltage levels.

Referring to FIGS. 1, 2, and 7 together, an illustrative flow diagram of an illustrative method for operating structure 102 is discussed. Methods of the disclosure may include, e.g., process P1 of generating input signal Vin for transmission to differential amplifiers 110, 112 (FIG. 2) of structure 102. The generating of input signal Vin may include, e.g., operating signal source 104 by providing supply voltage Vss thereto, while also transmitting signals ("Vdat") that may be converted into and/or selected for transmission as input signal Vin to structure(s) 102. The generating of input signal Vin furthermore may include generating reference voltage Vref, e.g., by transmitting supply voltage Vss to reference voltage generator 108. Reference voltage generator 108, in turn, outputs reference voltage Vref.

Methods of the disclosure proceed by transmitting input voltage Vin to differential amplifiers 110, 112 (FIG. 2), each having a distinct input offset (i.e., defined using offset component 120, 122 (FIG. 2) in each differential amplifier 110, 112). Process P2A of the disclosure includes transmitting input signal Vin to first differential amplifier 110, which may have a first input offset defined by offset component 120. Process P2B of the disclosure also includes transmitting input signal Vin to second differential amplifier 112, which may have a second input offset defined by offset component 122. Reference voltage generator 108 (FIG. 1) may transmit reference voltage Vref to each differential amplifier 110, 112 as processes P2A, P2B are implemented. Despite the same input signal Vin and reference voltage Vref being transmitted to each differential amplifier 110, 112, the input offsets created by each offset component 120, 122 will produce different voltage outputs as discussed herein. Process P2A thus produces output Out1 from first differential amplifier 110 and process P2B produces output Out2 from second differential amplifier 112.

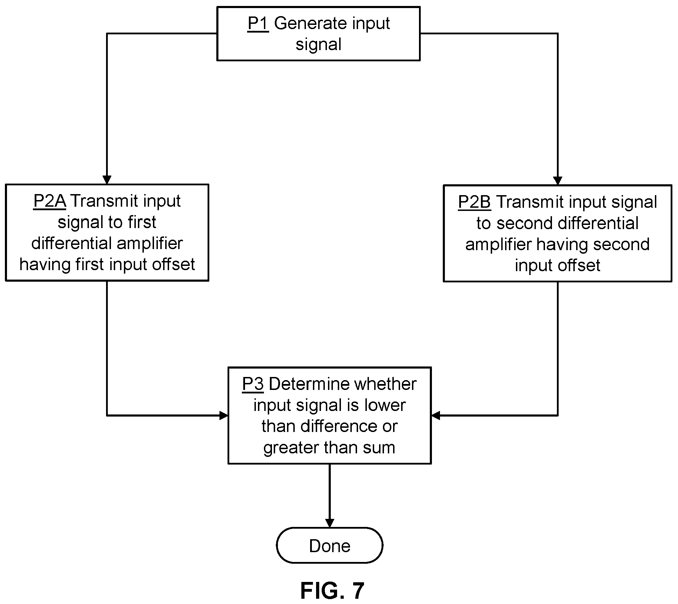

Methods of the disclosure also may include process P3 of determining whether input signal Vin is lower than the difference between input voltage Vin and the first input offset, and/or whether input signal Vin greater than the sum of input voltage Vin and the second input offset. The determining in process P3 can be implemented using digital circuit 106 (FIG. 1), logic gate(s) 126 (FIG. 6), and/or any other currently known or later developed instrumentation for generating a signal based on the logic level and/or magnitude of outputs Out1, Out2. In some implementations, process P3 includes generating (e.g., in digital circuit 106 and/or logic gate(s) 126) output signal Vout indicating whether input voltage Vin is greater than a lower compared voltage and less than an upper compared voltage. It is emphasized that methods of the disclosure may be implemented substantially in accordance with the operational methodology shown in FIG. 7 and discussed herein, regardless of how structure 102 and components thereof are embodied. In any case, the method may conclude ("Done") upon completing process P3, and/or may be repeated for multiple input signals and/or structures 102.

Embodiments of the disclosure provide various technical and commercial advantages, examples of which are discussed herein. Embodiments of structure 102 are operable to provide a window comparator circuit using only differential amplifiers, and without additional circuitry and/or components for modifying or interpreting input voltages provided thereto. In contrast to conventional circuits, embodiments of the disclosure omit the use of current source circuitry, resistive couplings, and/or other external hardware otherwise required to generate multiple reference voltages for comparison. Embodiments of the disclosure instead may create and rely upon voltage offsets created within two differential amplifiers 110, 112 (e.g., by asymmetrically sized transistors or resistors therein) to compare input signal Vin with two different voltages using only one reference voltage Vref for each differential amplifiers 110, 112. Additionally, embodiments of the disclosure do not apply significant electrical load to input signal Vin and thus do not distort any information encoded within input signal Vin. Embodiments of the disclosure are thus particularly suitable for use with highly sensitive signals (e.g., those generated in signals having high amounts of input resistance).

As used herein, the term "configured," "configured to" and/or "configured for" can refer to specific-purpose patterns of the component so described. For example, a system or device configured to perform a function can include a computer system or computing device programmed or otherwise modified to perform that specific function. In other cases, program code stored on a computer-readable medium (e.g., storage medium), can be configured to cause at least one computing device to perform functions when that program code is executed on that computing device. In these cases, the arrangement of the program code triggers specific functions in the computing device upon execution. In other examples, a device configured to interact with and/or act upon other components can be specifically shaped and/or designed to effectively interact with and/or act upon those components. In some such circumstances, the device is configured to interact with another component because at least a portion of its shape complements at least a portion of the shape of that other component. In some circumstances, at least a portion of the device is sized to interact with at least a portion of that other component. The physical relationship (e.g., complementary, size-coincident, etc.) between the device and the other component can aid in performing a function, for example, displacement of one or more of the device or other component, engagement of one or more of the device or other component, etc.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

In summary, the following embodiments are explicitly disclosed.

### Embodiment 1:

A structure comprising:
a first differential amplifier coupled to an input line, a reference line, and a first output line, wherein the first differential amplifier has a first input offset; and
a second differential amplifier coupled to the input line, the reference line, and a second output line, wherein the second differential amplifier includes a second input offset in a different direction from the first input offset.

In some illustrative examples herein, the reference line may have a reference voltage, e.g., the reference voltage optionally being generated by a reference voltage generator such as a hardware or voltage source coupled to the reference line and being configured to apply a reference voltage to the reference line.

### Embodiment 2:

The structure of embodiment 1, further comprising:
a first pair of asymmetrically sized transistors within the first differential amplifier configured to define the first input offset, wherein the input line is coupled to a larger size transistor and the reference line is coupled to a smaller size transistor of the first pair of asymmetrically sized transistors; and
a second pair of asymmetrically sized transistors within the second differential amplifier configured to define the second input offset, wherein the input line is coupled to a smaller size transistor and the reference line is coupled to a larger size transistor of the first pair of asymmetrically sized transistors.

### Embodiment 3:

The structure of embodiment 1 or 2, wherein the first differential amplifier and the second differential amplifier each include a pair of asymmetrically sized resistors configured to define the first input offset or the second input offset.

### Embodiment 4:

The structure of one of embodiments 1 to 3, wherein the first differential amplifier and the second differential amplifier are free of resistive couplings to the reference line.

### Embodiment 5:

The structure of one of embodiments 1 to 4, wherein a magnitude of the first input offset is substantially equal to a magnitude of the second input offset.

### Embodiment 6:

The structure of one of embodiments 1 to 5, further comprising an XOR gate coupled to the first output line and the second output line. For example, the structure may further comprise a digital circuit coupled to the first output line and the second output line, the digital circuit being configured to indicate whether a voltage in the input line is lower than a difference between the reference voltage and the first input offset or greater than a sum of the reference voltage and the second input offset, and the digital circuit may comprise the XOR gate.

### Embodiment 7:

The structure of one of embodiments 1 to 6, wherein the first differential amplifier and the second differential amplifier are within a window comparator circuit.

### Embodiment 8:

The structure of one of embodiments 1 to 7, wherein the reference line has a reference voltage, and wherein the structure further comprises a digital circuit coupled to the first output line and the second output line, the digital circuit being configured to indicate whether a voltage in the input line is lower than a difference between the reference voltage and the first input offset or greater than a sum of the reference voltage and the second input offset

### Embodiment 9:

A structure comprising:
a first differential amplifier coupled to an input line, a reference line having a reference voltage, and a first output line, wherein the first differential amplifier has a first input offset;
a second differential amplifier coupled to the input line, the reference line, and a second output line, wherein the second differential amplifier has a second input offset in a different direction from the first input offset; and
a digital circuit coupled to the first output line and the second output line, wherein the digital circuit is configured to indicate whether a voltage in the input line is lower than a difference between the reference voltage and the first input offset or greater than a sum of the reference voltage and the second input offset.

In some illustrative examples herein, the reference line may have a reference voltage, e.g., the reference voltage optionally being generated by a reference voltage generator such as a hardware or voltage source coupled to the reference line and being configured to apply a reference voltage to the reference line.

### Embodiment 10:

The structure of embodiment 8 or 9, further comprising a first pair of asymmetrically sized transistors within the first differential amplifier configured to define the first input offset, wherein the input line is coupled to a larger size transistor and the reference line is coupled to a smaller size transistor of the first pair of asymmetrically sized transistors; and
a second pair of asymmetrically sized transistors within the second differential amplifier configured to define the second input offset, wherein the input line is coupled to a smaller size transistor and the reference line is coupled to a larger size transistor of the first pair of asymmetrically sized transistors.

### Embodiment 11:

The structure of one of embodiments 8 to 10, further comprising:
a first pair of asymmetrically sized resistors within the first differential amplifier configured to define the first input offset, wherein the input line is coupled to a first transistor having a source/drain (S/D) terminal coupled to a larger size resistor and the reference line is coupled to a second transistor having an S/D terminal coupled to smaller size resistor of the first pair of asymmetrically sized resistors; and
a second pair of asymmetrically sized resistors within the second differential amplifier configured to define the second input offset, wherein the input line is coupled to a third transistor having an S/D terminal coupled to a smaller size resistor and the reference line is coupled to transistor having an S/D terminal coupled to a larger size resistor of the second pair of asymmetrically sized resistors.

### Embodiment 12:

The structure of one of embodiments 8 to 11, wherein the first differential amplifier and the second differential amplifier are free of resistive couplings to the reference line.

### Embodiment 13:

The structure of one of embodiments 8 to 12, wherein a magnitude of the first input offset is substantially equal to a magnitude of the second input offset.

### Embodiment 14:

The structure of one of embodiments 8 to 13, wherein the digital circuit an XOR gate coupled to the first output line and the second output line.

### Embodiment 15:

The structure of one of embodiments 8 to 14, wherein the first differential amplifier and the second differential amplifier are within a window comparator circuit.

### Embodiment 16:

A method comprising:
transmitting an input signal to a first differential amplifier via an input line, wherein the first differential amplifier is coupled to a reference voltage and has a first input offset;
transmitting the input signal to a second differential amplifier via the input line, wherein the second differential amplifier is coupled to the reference voltage and has a second input offset in a different direction from the first input offset; and
determining, based on an output from the first differential amplifier and an output from the second differential amplifier, whether the input signal is lower than a difference between the reference voltage and the first input offset or greater than a sum of the reference voltage and the second input offset.

### Embodiment 17:

The method of embodiment 16, wherein the first differential amplifier and the second differential amplifier each include a pair of asymmetrically sized transistors configured to define the first input offset or the second input offset.

### Embodiment 18:

The method of embodiment 16 or 17, wherein the first differential amplifier and the second differential amplifier each include a pair of asymmetrically sized resistors configured to define the first input offset or the second input offset.

### Embodiment 19:

The method of one of embodiments 16 to 18, wherein the first differential amplifier and the second differential amplifier are free of resistive couplings to a reference line having the reference voltage.

### Embodiment 20:

The method of one of embodiments 16 to 19, wherein a magnitude of the first input offset is substantially equal to a magnitude of the second input offset.

### Embodiment 21:

The method of one of embodiments 16 to 20, wherein the determining includes transmitting the output from the first differential amplifier and the output from the second differential amplifier to an XOR gate.

### Embodiment 22:

The method of one of embodiments 16 to 21, further comprising operating the structure of one of embodiments 1 to 15.

In accordance with some of the embodiments 1 to 22 above, a structure with differential amplifiers each having an input offset, and related methods are provided. In examples herein, a structure includes for example a first differential amplifier coupled to an input line, a reference line, and a first output line. The first differential amplifier may have a first input offset and a second differential amplifier may couple the input line and the reference line to a second output line, wherein the second differential amplifier has a second input offset in a different direction from the first input offset.

## Claims

1. A structure comprising:
a first differential amplifier coupled to an input line, a reference line, and a first output line, wherein the first differential amplifier has a first input offset; and
a second differential amplifier coupled to the input line, the reference line, and a second output line, wherein the second differential amplifier includes a second input offset in a different direction from the first input offset.

2. The structure of claim 1, further comprising:
a first pair of asymmetrically sized transistors within the first differential amplifier configured to define the first input offset, wherein the input line is coupled to a larger size transistor and the reference line is coupled to a smaller size transistor of the first pair of asymmetrically sized transistors; and
a second pair of asymmetrically sized transistors within the second differential amplifier configured to define the second input offset, wherein the input line is coupled to a smaller size transistor and the reference line is coupled to a larger size transistor of the first pair of asymmetrically sized transistors.

3. The structure of claim 1 or 2, wherein the first differential amplifier and the second differential amplifier each include a pair of asymmetrically sized resistors configured to define the first input offset or the second input offset.

4. The structure of one of claims 1 to 3, wherein the first differential amplifier and the second differential amplifier are free of resistive couplings to the reference line, and/or wherein the first differential amplifier and the second differential amplifier are within a window comparator circuit.

5. The structure of one of claims 1 to 4, wherein a magnitude of the first input offset is substantially equal to a magnitude of the second input offset.

6. The structure of one of claims 1 to 5, further comprising an XOR gate coupled to the first output line and the second output line.

7. The structure of one of claims 1 to 6, wherein the reference line has a reference voltage, and wherein the structure further comprises a digital circuit coupled to the first output line and the second output line, the digital circuit being configured to indicate whether a voltage in the input line is lower than a difference between the reference voltage and the first input offset or greater than a sum of the reference voltage and the second input offset.

8. The structure of claim 7, further comprising:
a first pair of asymmetrically sized resistors within the first differential amplifier configured to define the first input offset, wherein the input line is coupled to a first transistor having a source/drain (S/D) terminal coupled to a larger size resistor and the reference line is coupled to a second transistor having an S/D terminal coupled to smaller size resistor of the first pair of asymmetrically sized resistors; and
a second pair of asymmetrically sized resistors within the second differential amplifier configured to define the second input offset, wherein the input line is coupled to a third transistor having an S/D terminal coupled to a smaller size resistor and the reference line is coupled to transistor having an S/D terminal coupled to a larger size resistor of the second pair of asymmetrically sized resistors.

9. The structure of claim 7 or 8, wherein the digital circuit comprises an XOR gate coupled to the first output line and the second output line.

10. A method, preferably operating the structure of one of claims 1 to 9, wherein the method comprises:
transmitting an input signal to a first differential amplifier via an input line, wherein the first differential amplifier is coupled to a reference voltage and has a first input offset;
transmitting the input signal to a second differential amplifier via the input line, wherein the second differential amplifier is coupled to the reference voltage and has a second input offset in a different direction from the first input offset; and
determining, based on an output from the first differential amplifier and an output from the second differential amplifier, whether the input signal is lower than a difference between the reference voltage and the first input offset or greater than a sum of the reference voltage and the second input offset.

11. The method of claim 10, wherein the first differential amplifier and the second differential amplifier each include a pair of asymmetrically sized transistors configured to define the first input offset or the second input offset.

12. The method of claim 10 or 11, wherein the first differential amplifier and the second differential amplifier each include a pair of asymmetrically sized resistors configured to define the first input offset or the second input offset.

13. The method of one of claims 10 to 12, wherein the first differential amplifier and the second differential amplifier are free of resistive couplings to a reference line having the reference voltage.

14. The method of one of claims 10 to 13, wherein a magnitude of the first input offset is substantially equal to a magnitude of the second input offset.

15. The method of one of claims 10 to 14, wherein the determining includes transmitting the output from the first differential amplifier and the output from the second differential amplifier to an XOR gate.
